# NEW EUROPEAN PATENT SPECIFICATION

(11) **EP 2 277 694 B2**
(45) Date of publication and mention of the opposition decision: **12.01.2022**
(45) Mention of the grant of the patent: 13.09.2017
(21) Application number: 10007553.0
(22) Date of filing: 21.07.2010
(51) Int. Cl.: B32B 7/02, B32B 27/32, H01L 31/0216, H01L 31/048, H01L 31/049, B32B 17/10, B32B 7/10, B32B 7/12, B32B 15/08, B32B 27/08, B32B 27/16, B32B 27/18, B32B 27/34, B32B 27/36, B32B 27/30

(54) **Photovoltaic modules using an adhesive integrated heat resistant multi-layer backsheet**
Photovoltaikmodule mit einer klebstoffintegrierten hitzebeständigen mehrschichtigen Rückseitenfolie
Modules photovoltaïques avec film support multicouche résistant à la chaleur et avec adhésif intégré

(30) Priority: 23.07.2009 EP 09009543; 18.12.2009 EP 09015706
(43) Date of publication of application: 26.01.2011
(73) Proprietor: RENOLIT Belgium N.V., 9700 Oudenaarde (BE)
(72) Inventor: Rummens, François, 1082 Bruxelles (BE)
(74) Representative: Zellentin & Partner mbB Patentanwälte

(56) References cited:
- EP-A1- 1 898 470
- EP-A1- 2 086 019
- EP-A1- 2 277 693
- EP-A2- 2 541 622
- WO-A1-01/35898
- WO-A1-2010/053936
- WO-A1-2011/009568
- WO-A2-99/04971
- JP-A- 2001 094 135
- US-A1- 2005 074 623

## Description

### FIELD OF THE INVENTION

The present invention relates to the use in photovoltaic (PV) modules of a backsheet (10) comprising at least a heat resistant layer (12c) reactive and attached by coextrusion to a MAH-grafted PolyPropylene based tie-layer (12b) provided at the side facing the active material (4).

Optionally further layer(s) (12a) are provided on top of layer (12b), being a Thermoplastic PolyOlefine (TPO) based layer i.e. a Flexible PolyPropylene and/or (co-)PE based layer(s).

Optionally a last layer (13b) is provided facing the active material (4) based on (co-)PE based tie-layer (13b), such layer providing good adhesion directly on the back-side of the active material (4), or attached barrier layers.

The layer of the backsheet (10), either (12b) or (12a) or (13b), facing the active layer (4) has a residual heat of fusion at lamination temperature of less than 30 J/g, preferably less than 5 J/g, preferably is melted.

The heat resistant reactive layer (12c) is preferably equipped at its other side with an external (Flexible)PolyPropylene based protective layer (11). An adhesive layer (12d), preferably on base of functionalized PP, is in this case provided between protective layer (11) and reactive layer (12c).

The intermediate layers (12a) improve the encapsulation of thick crystalline PV cells (4) and when provided with a tie-layer (13b) may substitute an EVA under adhesive layer (5)

Junction Boxes, sealing strips or other devices can be welded to the rear layer of such backsheet, especially on a FPP layer (11).

The backsheet is cost effective and can be produced without wet adhesive layers, in one step by coextrusion and/or colamination.

The backsheet can be combined with a not cross-linked upper adhesive layer, which eases the production process of the PV modules.

### BACKGROUND OF THE INVENTION

A photovoltaic module (also abbreviated PV module) comprises at least the following layers: a top layer (1), an active layer consisting of a photovoltaic material layer or light emitting layer (4) sandwiched between a front and a back electrode layer and an electrically insulating backsheet. Usually the top layer is connected with the active layer via an upper adhesive layer (2). In many cases the active layer is connected with the backsheet via a back adhesive layer (5). These layers can be attached to a substrate like a metal sheet or rigid plastic sheet, or protected by an e.g. scratch resistant protective layer or provided with yet another adhesive layer for connection to a junction box or mounting surface. Each of the layers could be comprised of two or more sublayers. Barrier layers can be included, especially onto the active layer.

The top layer is typically either a glass plate or, for flexible modules, a layer from fluorinated polymers like ETFE (ethylen tetrafluorethylene) or PVDF (polyvinylidene fluoride). Generally a transparent upper adhesive layer is present between the top layer and the active layer, most usually this upper adhesive layer is based on EVA (ethylene vinyl acetate), e.g. on crosslinked EVA like Vistasolar 486.10 (from Etimex). It is generally accepted that the EVA benefits from containing a glass fleece or glass fibres or glass beads.

For the active layer a multitude of photovoltaic materials is known, e.g. a-Si cells, tandem cells (a-Si, a-Si or a-Si, microcrystalline silicon, ...), triple junction a-Si/a-SiGe/a-SiGe, Organic PhotoVoltaic (OPV), CIGS, etc. which can also be provided in the multi layer form. In case of a glass top layer the active layer is often directly attached to the top layer. In flexible modules, the active layer is generally built on a flexible supporting film (plastic or metallic).

The back electrode is generally a metallic layer, like aluminium layer and the front electrode a transparent conductive oxide layer.

Beneath the active layer an insulating backsheet is necessary and typically connected to the active layer via a back adhesive layer from crosslinkable EVA. Crosslinkable EVA contains peroxides and often also silanes. According to the prior art a so called TPT (Tedlar /PET /Tedlar) film is very common as backsheet, which consists of the following layers, laminated with the help of supplementary adhesives:
- A polyvinylfluoride (e.g.Tedlar^{®}) film, Corona or flame treated on both sides (25 to 40 µm thick)
- a bi-component solvent based polyurethane (PUR) or epoxy adhesive layer (5 to 10 µm)
- a polyethyleneterephtalate (PET) film (typically 250 µm thick)
- a bi-component solvent based PUR or epoxy adhesive layer (5 to 10 µm thick)
- A polyvinylfluoride (e.g.Tedlar^{®}) film, Corona or flame treated on both sides (25 to 40 µm thick)

Such TPT foil is suitable as backsheet because of its unique combination of useful properties like electrical insulation, no or low UV aging, dimensional stability at module lamination temperature (150°C), excellent adhesion to EVA adhesive films, at least if surface treated, and to sealants and limited water vapor permeability. Such TPT foil has several drawbacks. It is very expensive to produce as each layer must first be produced and laminated afterwards with supplementary solvent based glues. It consists of halogenated material (Tedlar ^{®}) and hydrolysis sensitive materials (PET, PUR adhesives), which is a severe drawback for hot, humid, sunny climates. The scraps of such foil can't be recycled.

Thus, there exists a need for less costly materials that provide the same useful properties.

State of the art crosslinkable EVA adhesive are 0,460 mm thick film and made on base of EVA with around 30 % Vinyl Acetate. They contain peroxides and possibly silane adhesion promoters, UV absorbers, anti-oxydants and HALS light stabilizers. Useful EVA films formulation are e.g. described in WO 99/27588. They are well established as durable highly transparent adhesive layers. They are very useful to encapsulate thick crystalline Si PV cells (typically 250 µm) thanks to their ability to flow around the cells. But such adhesive films have an expensive composition and are difficult to produce. Their crosslinking occurs typically at around 145 - 150°C, typically during 15 minutes. Such curing process is delicate to control (bubbles generation during lamination/curing) and unacceptable shrinkage of the adhesive may occur, with undesired displacement of the PV cells (i.e. shift of PV cells).

Thus, there exists a need for replacement of such EVA adhesive layer, especially for back adhesive application.

More particularly, there exists a need of a cost effective, more easily (i.e. thermoplastic) recyclable backsheet with integrated adhesive replacing both in one foil the TPT backsheet and the EVA back adhesive and having easy processing features (no interlayer delamination during module production, good dimensional stability, no or acceptable cell shift during lamination, etc.).

US 2008/0023064 A1 and US 6 114 046 A and WO 99/04971 describe multi-layer adhesive films based on a core layer of transparent (co-)PolyEthylene (like Ethylene Acrylate Ester Copolymer or VLDPE) and external layers being based on acid copolymer, possibly partly neutralized (ionomers). Such multi-layer adhesive films are provided to replace EVA adhesive layer. Such multi-layer films may then be co-laminated or coextruded with a PP backsheet layer (US 2008/0023064 A1 and US 6 114 046 A don't disclose such feature), with initial good interlayer adhesion. However such adhesive film will debond from the PP backsheet layer during the PV module production process or lead to poor interlayer adhesion, with subsequent in use delamination.

The reason of such delamination is unclear. It is believed that as the mainly PE based adhesive layer is melted during the production process of the PV module (usually around 145°C) and the mainly PP based backsheet remains in a not melted state, the mainly PE based adhesive layer is submitted under the pressure of PV module production, to lateral flow. (Pre-)delamination occurs. On cooling, no co-cristallization is possible between the PP layer and the mainly PE based adhesive, to restore adhesion.

US 2008/023063 A1 discloses similar possibly multi-layer adhesive films (called first encapsulant layer) as US 2008/0023064 A1. The adhesive layer (tie-layer) is in this case derived from an ionomeric composition. Such tie-layer can be heated and be caused to form an adhesive bond with other encapsulant layer materials, flexible plastic materials, rigid materials, and/or solar cells.

In this application PP is mentioned as backsheet plastic material in very general terms but PP based material is neither mentioned in the "Solar Cell Laminate Constructions" paragraph of the application nor in the extended list of examples.

To obtain appropriate adhesion between a PP based backsheet and the adhesive films, adhesives and primers are still required, with several processing steps. The issue of a durable adhesion of a tie-layer with a PP backsheet is not addressed.

The backsheets described in the paragraph "Solar Cell Laminate Constructions" are further not integrated with an adhesive layer, and in no case the described combinations of "adhesive/backsheet" are recyclable.

US 2006/0166023 A1 describes a backsheet consisting of a substrate (e.g. a PET film) equipped with a vacuum deposited inorganic barrier oxide layer, encapsulated by PolyOlefin films on both sides, such film being possibly on base of PP. A filler (an EVA film) is still used to adhere the backsheet to the backside of the cells. The issue of a durable adhesion of a tie-layer with a PP backsheet is not addressed. Such film is expensive and (their scraps) can't be recycled.

EP 1 898 470 A1 discloses a multi-layer backsheet comprising a central barrier film on base of an inorganic oxide deposited on a substrate film (e.g. a PET film). The central film layer is adhered with the help of adhesives like PUR or epoxy adhesives to:
- a front resin film which comprises polyolefin as a principal component, for instance a copolymer of polypropylene, which shows adhesiveness to classical EVA back adhesive layer (filler layer).
- a backside film being for instance a PET film containing containing expensive carbodiimide anti-hydrolysis substance.
Such backsheet is used with and has adhesiveness with classical EVA adhesive. The issue of a durable adhesion of a tie-layer with a PP backsheet is not addressed. Such film is expensive and (their scraps) can't be recycled.

US Patent 5,762,720 discloses a Thermoplastic PolyOlefin backskin (backsheet) providing direct adhesion to the backside of the PV cells. Such backsheet is based on a blend of ionomers. Ionomers are rigid, with the risk of cell damage during production and in use. Ionomers are further expensive. They have a tendency to flow during module manufacturing because they are melted at usual lamination temperature (around 148°C). Lower production temperature may be used but with the risk of cell damage and requires a longer contact time with the backside of the PV cells to obtain adhesion and such lower temperature is not compatible with the crosslinking requirements of EVA adhesive layer (if used as upper adhesive layer).

US Patent 6,660,930 B1 discloses a backskin (backsheet) foil providing direct adhesion to the backside of the PV cells and based on a Nylon/ionomer alloy. Such patent application shows the importance of a heat resistance backsheet to avoid any likelihood of it being pierced by any of the components that interconnect the solar cells. However to obtain adhesion to the still used under adhesive layer (an ionomer film or EVA film), the said back sheet need to be Corona treated, which renders the production of a one foil adhesive integrated backsheet more complicated. Ionomers and ionomer/Nylon blends are further expensive.

Recycling, especially end of life recycling of the PV module equipped with such material is far from obvious.

EP application No 08001991 provides in its third embodiment a PV waterproofing membrane as follows (starting from the frontsheet to the backside):
a) An ETFE film 50 µm (with classical atmospheric plasma treatment to adhere to EVA)
b) Two EVA Vistasolar 486.10 films of +/- 460 µm
c) Several 50 µm aligned in parallel PEN films supporting the active layers (stripes of interconnected TCO/pin/back electrode) and interconnected. The back side of the PEN film is e.g. treated by reactive sputtering (deposition of a nano-layer of Al₂O₃) to improve adhesion with the Primacor (EAA) film.
d) A coextruded multi-layer of:
   - i) 50 µm Primacor 1410 or 1321
   - ii) 50 µm Exact 0203
   - iii) 50 µm Exact 0203/Hifax CA 60/Versify 2400.00 in mixture
e) A 1.2 mm TPO sheet on base of a Flexible PolyPropylene, Hifax CA 10 A

Embodiment 3 of EP 08001991 is directed to Photovoltaic waterproofing membrane and don't disclose clearly the advantage of the TPO intermediate layers d)-iii) as an effective InterPeNetrated "compatibilizing resin blend" between:
- "tie-layer d)-i) (Polyethylene co acrylic acid Primacor 1410 or 1321)"/TPO d)-ii) intermediate layer 2 (VLDPE Exact 0203)" and
- the TPO membrane on base of Hifax CA 10 A being an "interpenetrated network op PP with EPR rubber"
Such construction allows anyway for "excellent adhesion" even after 3 months of immersion in water 60°C.

However the man skiled in the art is left in doubt to what the technical feature "excellent adhesion" refers and wich problem is effectively adressed.

Further the embodiment is limited to the very specific case of a PV waterproofing membrane. The possibility of effective encapsulation of thick crystalline PV cells is not clarified.

TPO layers on base of Hifax CA 10 A suffer also from limited mechanical integrity at the usual lamination temperature (around 150°C). The material has a tendency to flow at such temperature with connected issues like shrinkage, undesired cell shift, flow of material above the PV cells (material flows from under the PV cells and covers partly the edges and the visible surface of these cells leading to aesthetical damages).

In the above mentioned patents, the adhesive layer is generally not pigmented, which increases the risk of discoloration (more pronounced yellowing). When the adhesive layer is colored anyway, there is an increased risk of aesthetical defects in the sense that the adhesive integrated backsheet "flows" during the lamination process under the effect of heat and pressure. Some material may then flow above the PV cells leading to aesthetical defects, especially when the adhesive layer is light color pigmented.

To the knowledge of the inventor, no backsheets are disclosed allowing to attach a junction box by means of welding (high reliability / durability of the bond) instead of gluing. It is also the case for the connection of the backsheet with the aluminium frame, which is generally obtained today by a silicone bead. Such connection can't assure watertightness. Watertightness is required for building integrated application where the module replaces waterproofing elements of the building.

Thus, there exists a need of PV modules with a cost effective, preferably recyclable improved adhesive integrated heat resistant backsheet, with good dimensional stability and mechanical integrity at processing temperature and with excellent internal adhesion even after module production. The adhesive layer of such backsheet should be preferably soft enough to avoid cell damage during module production and in use. It should be capable of encapsulating thick crystalline PV cells.

Further, there exists the need of PV modules with a watertight connection between the backsheet and the aluminium frame of the PV module.

Further, there exists the need of PV modules where the junction box is welded to the backsheet, because such solution is more reliable and no time is required for crosslinking of adhesive sealant.

Further there exists the need of PV modules which can be produced without the crosslinking step, i.e. avoiding the use of an EVA upper adhesive layer and there exists the need to address the limitation of such EVA film as disclosed in patents US 2008/0023064 A1 and US 6 114 046 A and WO 99/04971.

All above described patent are included in this application by reference. In particular the several disclosed tie-layers are useful for this invention. Other tie-layers are useful like partly neutralized amine based ionomers. Addition of glass fibers, glass beads, glass fleece, reinforcement, etc are relevant to improve the mechanical integrity of the backsheet. Previously disclosed non yellowing stabilizers systems, pigments, fire retardants, surface treatments, etc. are useful.

The present application claims priority of EP09015706, of which text is incorporated within the present application by reference.

This application describes the use of backsheet with integrated adhesive of the following structure:
- Backsheet:
   (F)PP based layer (11b) / PPgMAH based layer (11a) / PA or EVOH based reactive layer (11)
- Integrated adhesive
   Functional PE based tie-layer (12b) / Intermediate PE Plastomer layer (12a), providing quality of encapsulation / Functional PE based "tie-layer" (13b)

### SUMMARY OF THE INVENTION

To solve the objects of the invention, one provides:

### A) A possibly adhesive integrated backsheet (10) being produced on base of:

### A.1) A heat resistant (multi-layer) layer, with residual heat of fusion at lamination temperature, comprising:

- possibly a multi-layer (F)PP based protective layer (11) with UV stabilizers, pigments, etc.
- possiby a functionalized adhesive layer (12d), e.g. a PP grafted with MAH based layer, reacting during extrusion with reactive layer (12c) and providing adhesion with layer (11)
- a reactive layer (12c) on base of a reactive polymer, namely EVOH or co-Polyamide (PA), with functional PO tie-layers (e.g. co-PE with functional groups or PP grafted with MAH).

The polymeric components of the heat resistant layer are selected for their ability to achieve a residual heat of fusion (polymeric part) of such layer, preferably of at least 10 J/g, most preferably of at least 20 J/g, at lamination temperature.

A sufficient residual heat of fusion at lamination temperature means a lot of desirable properties, like limited shrinkage and thermal (flow) resistance, under the lamination conditions of PV modules (typically 1 atm pressure, 150°C temperature and 30 minutes time). Related issues are cell movements, mechanical damage (risk of perforation of the backsheet), contamination of the straps of the laminator, aesthetical defects, etc.

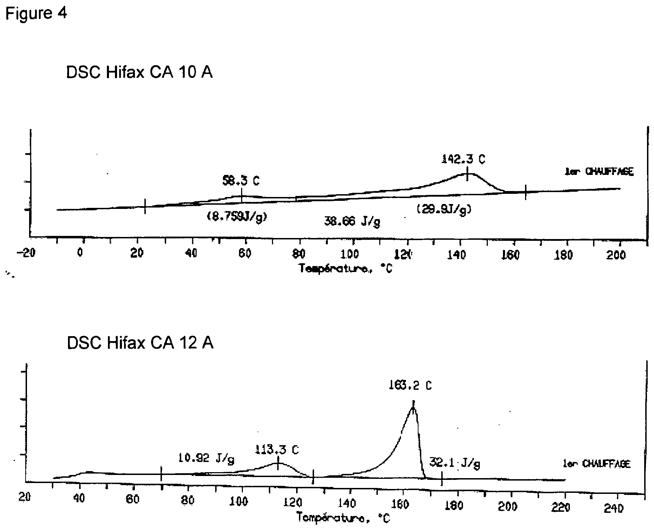

The residual heat of fusion is measured by DSC and the method of measurement is explained related to figure 4.

The reactive layer (12c) is on base of polymers having available reactive chemical moeitities (reactive groups like NH3, OH, etc.), namely (co-)Polyamide or EVOH.

The functionalized adhesive layer (12d) is typically on base of a PP grafted with MAH and is provided between and attached to layers (11) and (12c), preferably by coextrusion.

The external layer (11) is on base of a Polypropylene blend and is preferably a multi-layer layer with a layer facing the Junction Box (601) preferably on base of a Flexible PP blend.

Preferably the reactive layer (12c) is recyclable and consists of thermoplastic polymer based materials selected to achieve good mechanical integrity (enough dimensional stability, limited heat distorsion and limited unpleasant flow) during PV module production, meaning a.o. less risk of perforation by components interconnecting the PV cells, less risk of cell shift (movement of PV cells), less risk of aesthetical flaws (unpleasant flow), etc.

The total thickness of the heat resistant main layer (100) is typically between 0,3 and 0,6 mm to achieve a system Voltage of 1000 VDC or more.

### A.2) A tie-layer (12b):

Such layer (12b) is provided in contact with the reactive layer (12c) and is based on a PolyPropylene grafted with maleic anhydride (MAH).

### A.3) Optionally layer (12a):

Such layer (12a) is provided in contact with layer (12b) and is based on a TPO blend, with a low residual heat of fusion at lamination temperature.

It may be a multi-layer layer. Useful TPO are (blends of) Flexible PolyPropylene and (co-)PolyEthylene.

A FPP blend based layer is required in contact with layer (12b) when such tie-layer is based on a MAH grafted PP or similar.

Preferably the layer of layer (12a) facing the PV cells is based on LLDPE and/or VLDPE and/or OBC resin (a type of VLDPE provided by Dow Chemical) and/or co-polymer of PE with a polar comonomer.

Layer (12a), if required, has adapted thickness ranging typically from 50 to 500 µm, adapted viscosity and low residual heat of fusion to flow properly e.g. no excessive lateral flow under pressure and adequate flow between crystalline PV cells (4), and sufficient softness to releave e.g. PV cells (4) from internal tensions.

Controlled lateral flow under the vertical pressure of the PV module laminator is required to avoid visual defects within PV modules (cells shift, material flowing above the PV cells, with visual defect if such material is pigmented, ...).

### A.3) Optionally tie-layer (13b) with low residual heat of fusion, preferably melted at lamination temperature.

Such layer (13b) is provided in contact with layer (12a) and is preferably based on a functionalized (co-)PE.

The layer (13b) facing the PV cells (4) possibly functioning as the back adhesive layer (tie-layer) is based on functional polyethylene grafted or copolymerized with reactive groups, like acrylic acid, methacrylic acids, maleic anhydride, glycidyl methacrylate, hydroxyalkylacrylate and possibly copolymerized with polar comonomers chosen from vinyl acetate (VAc), acrylic ester (methylacrylate, ethylacrylate, butylacrylate, ethylhexylacrylate), etc.

Such layer has a residual heat of fusion at usual lamination temperature (> 135°C) which is zero. Such layer is therefore able to develop its adhesion to the backside of PV cells or PV cells supporting films and also, in order to provide effective encapsulation, to the PV module top layers (i.e. the upper adhesive layer if any or glass front layer with adequate surface treatment e.g. at the edges of the module, etc.) at moderate temperature of less than 150°C, even less than 140°C.

In particular, such completely melted tie-layer at lamination temperature of usually around 150°C develops excellent adhesion to usual EVA encapsulants.

Polyethylene MAH grafted and possibly copolymerized with VAc is preferred.

The several layers (11) / (12d) / 12c/ (12b/12a) / 13b (or possibly (11) / (12d) / 12c / 12b / 12a) are produced and brought together by coextrusion of 2 stacks of several layers and further co-lamination of these stacks of several coextruded layers, in line or during the lamination process of the PV modules.

To achieve excellent adhesion, each coextruded multi-layer stack may have as to be laminated on external layer, the same layer it will be colaminated to. Such common layer will preferably be the PE-based tie-layer (12b)

The resins or blends used in the composition of layers (11), (12d), (12b), (12a), (13b) are considered by definition as TPO resins or blends.

The tie-layer (12d), (12b), (13b) are per definition PO based tie-layer.

### B) If required, an upper adhesive layer (2):

An EVA upper adhesive layer may still be used or replaced e.g. by a ionomer film or any film described in e.g. US 2008/0023064 A1 and US 6 114 046 A and WO 99/04971, and "RWW7157 EP", i.e. a multi-layer adhesive films based on a core layer of transparent (co-)PolyEthylene (like Ethylene Acrylate Ester Copolymer or VLDPE), possibly partly cross-linked, and external layers being based on PE with functional groups, e.g. acid copolymer, possibly partly neutralized (ionomers).

All layers of the backsheet (10) may be pigmented with e.g. at least 5 % weight of white pigments like TiO₂ allowing achieving a high solar reflectance and reduced in use yellowing.

The obtained backsheet (10) shows a surprising combination of many of the following desirable properties: reliable adhesion with backside of the cells (4), in case a tie-layer (12b or 13b) comes in direct contact with the PV cells, with peroxide crosslinkable EVA adhesive layer (2 or 5), enough barrier properties (better than classical Tedlar/PET/Tedlar backsheet), enough dimensional stability (< 1 % 30 minutes 150°C - PP part of the backsheet), mechanical properties retention (integrity) and limited heat distortion (flow) at usual vacuum lamination process, excellent aging (a.o. resistance to hydrolysis, UV stability), excellent electrical properties (> 1000 VDC partial discharge Voltage), excellent mechanical properties and weldability to junction boxes, high solar reflectance.

### C) A transparent top layer (1) (glass plate, fluoropolymer film, etc.)

The glass plate or polymeric film may be beforehand treated with e.g. amino-silanes or another surface treatment like by CVD of an aluminium oxide nano-layer (i.e. by pyrolitic decomposition at +/- 550°C of an aerosol of an Aluminium salt at the exit of the floating production step of the glass; intermediate layer may be required to improve adhesion on glass, as well known by the man skilled in the art). Such Glass with aluminium oxide nano-layer shows excellent and durable bonds with (co-)PE based tie-layers with e.g. acrylic acid or MAH functional groups, even at relatively low module lamination temperature (e.g. 140°C).

### D) An active layer (Interconnected PVcells, ...) (4), possibly encapsulated and/or provided with barrier layers and/or provided on a flexible substrate and/or produced and integrated on the top layer (1) being a superstrate.

Further, the active layers (e.g. interconnected crystalline Si PV cells) (4) are laminated at moderated temperature (typically < 155°C, preferably around 145°C) with the backsheet (10) integrating the back adhesive layer (12 b or 13b) beneath and above, the transparent upper adhesive film (2), if required and a transparent top layer (1), being e.g. a glass plate.

Alternatively a under adhesive EVA layer (5) may be provided between the active layers (4) and the backsheet (10).

Framing/mounting elements, electrical connections and application of a junction box are further done.

In case of the backsheet (10) consists of a thermoplastic rear face (face coming into contact with the junction box), it is further possible to weld a junction box to this rear phase. It is preferred to have a rear layer of the backsheet on base of a coextruded FPP composition (11) to ease the welding process.

Most preferably, the rear face will consist of a FPP composition close to the compositions which are used for the production of FPP waterproofing membrane as disclosed in EP 08001991, as such compositions excel in UV stability, fire properties and weldability.

To be able to weld by any suitable technique (hot wedge, etc.), the junction box (601) to the rear face of the backsheet (10), one produces the Junction Box by injection over molding of e.g. a PA 6-6 based composition on possibly a multi-layer ring film (602) having the size of the base of the junction box, such film consisting e.g. of:
- a first thin layer (typically 50 µm) - (602 a) coming into contact with the PA 6-6 based injected base of the Junction Box, such first layer being based on acid functionalized PP like a MAH grafted PP composition
- a second thicker layer (typically up to 2 mm) - (602 b/602 c) - coming into contact with the PP backsheet (10), being preferably based on a FPP with good welding properties with the PP backsheet.

To achieve a watertight sealing of the backsheet of the module film the Aluminium frame (6001), one provides by "hand" extrusion (e.g. with a Leister hand extruders) a extruded rod of an acid functionalized FPP based compound like on base of a MAH grafted FPP composition. This rod is extruded between the aluminium frame and the rear face of the PP backsheet, in the cavity defined by frame (6001), backsheet (10) and extruder head (6002).

Cost effective and durable modules can be produced on base of the obtained backsheet (10), possibly in combination with an uncrosslinked upper adhesive layer (2).

### DETAILED DESCRIPTION OF THE INVENTION

Typical EVA adhesive (2 or 5): A typical crosslinkable EVA adhesive film containing peroxide crosslinkers and silane adhesion promoters is sold by Etimex under the trade name Vistasolar 486.10 (the base resin of such a film is an EVA with around 33 % VAc like Elvax 150). The content of peroxide in the EVA adhesive layer can advantageously be increased to compensate for the loss by migration into the backsheet of this invention.

Upper adhesive layer (2): Useful upper adhesive layer within the scope of this invention are crosslinkable EVA adhesive layer or are replaced e.g. by a ionomer film or any film described in e.g. US 2008/0023064 A1 and US 6 114 046 A and WO 99/04971, and "RWW 7157 EP", i.e. a multi-layer adhesive film based on a core layer of transparent (co-)PolyEthylene (like Ethylene Acrylate Ester Copolymer or VLDPE or OBC), possibly partly cross-linked, and external layers being based on PE with functional groups, e.g. acid copolymer, possibly partly neutralized (ionomers).

### Reactive layer (12c):

The reactive layer (12c) consists of a reactive layer providing adhesion by heat with optionally PP based tie-layers (12d and possibly 12b) and with PE based tie-layer(s) (12b and/or 13b).

The reactive layer (12c) is preferably based on thermoplastic polymers and the adhesion with tie-layers (12b, 13b, 12d) is provided during the coextrusion production step (or extrusion coating) of the backsheet (10).

Useful reactive polymers are EVOH and (co-)Polyamides, with active chemical groups like Hydroxyl (OH) group or Amine (e.g. NH3) group, etc..

EVOH and PA react with tie-layers comprising acidic functionalities (Acrylic Acid, Maleic AnHydride; ...).

Typical reaction temperatures, i.e. coextrusion temperatures are between 250 and 300 °C.

### Tie-layers (12d, 12b, 13b)

Layers (12d) and (12b) are tie-layers providing good adhesion to reactive layer (12c). Usefully, tie-layer (12d) is e.g. based on PP (homo or RandomCoPolymer) grafted with maleic anhydride. Layer (12b) may have similar composition as layer (12d). Layer (13b) is based on (co-PE) grafted or copolymerized with functional groups (gycidyl methacrylate, acrylic acid, methacrylic acids, maleic anhydride (MAH), (partly neutralized) ionomers, etc.).

The content of MAH in MAH grafted functional PE is typically around 0,2 % but may be increased if required to improve adhesion. PE grafted with Maleic Anhydride are supplied e.g. by Arkema under the trade name Orevac (Orevac 18300, 18360, ...). Orevac 18300 is particularly useful.

Useful EAA (PE co-Acrylic Acid) resins are supplied e.g. by Dow under the trade name of Primacor ^{®} (Primacor 1321 or 1410).

EVA grafted with MAH are well known for their clarity (Plexar^{®} PX1164).

Grafting of silane (e.g. Gamma-Methacryloxypropyl trimethoxysilane), acidic (e.g. acrylic acid), hydroxyl (e.g. hydroethylacrylate), etc. functionalities to the surface (12a) of the backsheet or electrical insulation layers on substrate, adjacent the crosslinkable EVA adhesive film (2) and/or cells (4), by e.g. plasma techniques, are well known in the art, and are also useful. Such functionalized surface are by extension considered as coextruded or colaminated "functional PE tie-layer". For example, the surface of the said face (12a) of the backsheet is first Corona or Plasma treated to improve wetting, then coated with a thin wet film of a diluted solution of molecules containing reactive groups like silane groups (Gamma-Methacryloxypropyl trimethoxysilane), then dried to evaporate the solvent and then cured (grafting reaction of acrylate) by atmospheric plasma or another grafting technique (gamma grafting, ...). The solvent is selected for its ability to solvate the TPO layer (12a), i.e. allowing some penetration of the reactive groups containing molecules. Of course the TPO surface has to have a low residual heat of fusion, is preferably melted at lamination temperature.

The (co-)PE based tie-layer (13b) allows to obtain excellent adhesion, at lamination temperature as low as 150°C (PE based tie-layers), even as low as 140°C, with the surface of the backside of PV cells or cells supporting film or module top layer, having a surface consisting of aluminium (usually the case of the back electrodes of PV cells), aluminium oxide (deposition by e.g. reactive sputtering or CVD) and/or that are treated by an appropriate surface treatment (e.g. amino-silane wet coating of glass) to develop functionalities able to react with the functional group of the polymer of the tie-layer.

### Protective (F)PP layer (11)

The protective (F)PP layer (11) may be a mono or a multi-layer and is mainly based on PolyPropylene, preferably on homo-polymer PP, preferably impact modified and/or on Flexible PolyPropylene (FPP), which includes by definition impact modified PP.

Such layer is UV and heat stabilized and protects the reactive layer (12c) against hydrolysis and UV degradation.

Layer (11) is preferably a multi-layer layer, with a main layer in contact with the PP tie-layer (12d) on base of essentially Homo-Polymer and an external layer providing weldability with junction box on base of preferably a FPP reactor blend. Three-layer structures are also useful with a (preferably homopolymer, preferably impact modified) PP based core main central layer and other layers being e.g. FPP based.

The polymeric parts of the layers (11), (12d), (12c) are selected for their ability to provide a heat resistant layer (100 = 11/12d/12c) where its polymeric part has a residual heat of fusion, preferably of at least 10 J/g, most preferably of at least 20 J/g at lamination temperature.

Useful resins or blends for the production of layer (11):
- 1) flexible polypropylene (FPP) mechanical or reactor blends of PP resins (homo or copolymer) with EPR rubber (ethylene propylene rubber), like Hifax CA 10 A, Hifax CA 12, Hifax CA7441A, supplied by LyondellBasell,
Thermoplastic vulcanisates blends like Santoprene base blends. Such thermoplastic vulcanisates are based on blend of PP, with EPDM rubber and are considered within the scope of this invention as PP/EPR blends, which are partly crosslinked.
- 2) mechanical FPP blends of PP resins with elastomer PP resins (like supplied by Dow underthe trade name Versify 2300.01 or 2400.01),
- 3) mechanical FPP blends of PP with LLDPE (linear low densitiy polyethylene) or VLDPE (very low density polyethylene) plastomers (like Exact 0201 or Exact 8201 supplied by Dexplastomers), or copolymer of Ethylene with a polar comonomer like Vinyl Acetate or Alkyl Acrylates.
- 4) PolyPropylene, preferably homopolymer
- 5) blends of above mentioned (F)PP

### Intermediate layer (12a):

Intermediate layer (12a) may be mono or multi-layer.

Such layer serves at least one of the following purpose:
- If layer (12b) is a PP based material, to provide adhesion between (12b) and (13b), being a (co-)PE based material
- If an EVA under adhesive layer (5) is used or where the backsheet (10) comes into contact with an upper EVA adhesive (2), to provide improved adhesion with such layer (5) or (2).
- If thick PV cells (4) are used like crystalline PVC cells, to provide improved encapsulation of such cells.

The intermediate layer (12 a) is mainly useful for crystalline based cells modules and/or as a soft buffer layer to reduce tensions on the backside of the cells and has preferably at least a layer facing the PV cells being based on a PE blend, preferably a flexible PE blend like VLDPE, or OBC based blend or LLDPE preferably with softeners (UV stable Kraton type of resins, ...).

The 2% secant E modulus (ASTM D882) of such layer (12a) will usefully be lower than 250 MPa, preferably lower than 150 MPa, most preferably lower than 100 MPa.

FPP material may enter into the composition of (internal) layers of layer 12a. Such FPP layer(s) is particularly useful to provide good ahesion with layer (12b), when such layer is on base of a MAH grafted PP. In this case, layer (12a) will comprise a FPP layer on base of a blend forming an interpenetrated network of (co-)PolyEthylene resin and PP resin. Such interpenetrated network blend means that (co-)PE and PP phases are interlocked. The PP phase of the FPP layer provides adhesion to the PP based (MAH grafted) layer (12b) and the (co-)PE based phase of the FPP layer to the (co-)PE based layer: part of 12a facing the PV cells (4) or layer 13b.

Therefore such FPP layer serves the purpose of compatibilizing (i.e. provide excellent adhesion between) the (co-)PE-based layer (13b or (co-)PE layer of layer 13a) and e.g. MAH grafted PP based layer (12b).

Several FPP layers may further be used to gradually (better) compatibilize layers to be brought together (Rheology of extrusion and adhesion).

Such FPP layers are melted later than a (co-)PE based layer and will show a reduced tendency to flow during the lamination of the PV modules (or more in general electronic devices). This means less visual defects.

The interlocked blend is for example a blend based on following resins:
i. VLDPE resins like Exact 0203
ii. FPP reactor blend resins: like Hifax CA 10 A and Hifax CA 60
iii. An Elastomer PP resin, like Versify 2400.01, serving the purpose of improving the dispersion of i) within ii)

As further layer, a FPP layer on base e.g. of reactor blend resins like Hifax CA 10 A and Hifax CA 60 may be provided between layer 12 b and the interlocked blend based layer, to further improve internal adhesion.

FPP material which provide a low 2 % E modulus (< 250 MPa - ASTM D882) and/or a low residual heat of fusion at lamination temperature (< 30 J/g, preferably less tha 5 J/g) to layer (12a), are prefered.

The low residual heat of fusion and softness is particularly helpful to provide good encapsulation of thick cristalline PV cells.

The viscosity of the resin is also adapted to obtain the best encapsulation of the PV cells, i.e. appropriate flow during lamination.

Useful resins for the composition of layers of layer (12a) are generally:
- 1) PE block copolymers (OBC) resins of crystalline PE parts (blocks) and amorphous coPolyEthylene parts (blocks), like INFUSE^{™} olefin block copolymers supplied by Dow, providing softness and high DSC melting termperature (+/- 120°C)
- 2) polyethylene plastomers (VLDPE) or LLDPE, i.e. PE obtained by copolymerization of ethylene with short-chain alpha-olefins (for example, 1-butene, 1-hexene and 1-octene), with a density of less than 925 kg/m³ (ISO 1183), possibly (partially) crosslinked to improve heat distortion temperature and flow during lamination of PV modules,
- 3) copolymer of ethylene with polar comonomers chosen from vinyl acetate, acrylic ester (methylacrylate, ethylacrylate, butylacrylate, ethylhexylacrylate, gycidyl methacrylate), acrylic acid, methacrylic acids, maleic anhydride (MAH), possibly grafted, ionomers, etc.
- 4) FPP blends (see "Useful resins or blends for the production of layer (11)"), preferably with low residual heat of fusion (< 30 J/g, more preferably < 5 J/g) and/or low E modulus (2 % E modulus < 250 MPa - ASTM D882).
- 5) Blends of above described resins and blends.

Softener resin may be added to the composition of layer (12a), on base of e.g. LLDPE, like SEBS resin (e.g. Kraton G1657), EPR resin, EPDM resins, etc.

The layer (12a) may be (partly) crosslinked by any known method. It may consist of a Thermoplastic Vulcanisate blend of PE/EPDM.

Applying the above mentioned teaching, one obtains a typical backsheet of this invention (with FPP based intermediate layer (12a)):
- 1) typically 10 to 50 µm of a functional PE based tie-layer (13b)
- 2) typically a multi-layer (12a):
   1. typically 100 to 200 µm of a VLDPE or PE based layer possibly partly cross-linked (silane, ...) and provided with softener resins, facing (13b)
   2. typically 100 to 200 µm FPP layer based on an interpenetrated network mixture of PolyEthylene and PP based resins (e.g. a mixture based on VLDPE resin like Exact 0203 with PP reactor blend resins like Hifax CA 10 A and Hifax CA 60, and possibly with addition of a Elastomer PP like Versify 2400.01)
   3. typically 50 to 200 µm FPP layer based on a FPP reactor blend e.g. based on a blend of Hifax CA 10 A and Hifax CA 60
- 3) typically 10 to 50 µm of a PP (preferably RCP) grafted with maleic anhydride like Admer QF 551E (12b) reacting with the PA layer or EVOH layer.
- 4) typically 50 to 300 µm of a (co-)PA based, like PA 6 or EVOH based reactive layer (12c), able to react and stick to layer 3 and 5)
- 5) typically 10 to 50 µm of a PP (RCP or Homo PP) grafted with maleic anhydride based layer (like supplied by LyondellBasell - "Plexar 600x" product range, especially Plexar 6002 and 6006 resins), (12d) reacting with the PA layer or EVOH layer.
- 6) typically 100 to 400 µm of a (F)PP based layer (11) providing UV resistance, protection against humidity and weldability to junction box and containing homo PolyPropylene for achieving adequate mechanical integrity during PV module production.

The PA layer (12c) preferably contains anti-hydrolysis additives.

The layers can be coextruded and/or in-line colaminated.

It is preferred to use for layer (11) FPP resins with significantly higher (5°C) melting temperature than the module lamination temperature (see DSC analysis - figure 4 and MTM 15902).

Preferred techniques, which can be easily adapted by the man skilled in the art, to improve, if required, adhesion of PV module components with tie-layers of this invention are:
- deposition by reactive sputtering of a nanometric layer of Al2O3 on the backside of PV films or cells and/or on the transparent conductive oxide or barrier layer of PV cells,
- atmospheric plasma cementation (adapted from US patent 03030290) of ETFE film under e.g. N₂/NH₃ gas mixture (to maximize NH₂ reactive groups availability at the surface of the ETFE film),
- chemical vapor deposition (possibly plasma enhanced) of a nanometric layer of Al₂O₃ on glass,
- wet coating of glass with a thin layer of amino-silane (e.g. Aminopropyltriethoxysilane (H₂NC₃H₆-Si(OC₂H₅)₃)).

It is preferred to add to the composition of the backsheet (layers 12b/12a/13b) anti-oxidants, HALS and UV absorber which can migrate into the adhesive layer (2) to compensate possible loss of such additives by reaction with the peroxides (EVA adhesive) and/or by migration from the adhesive film towards the backsheet.

If required the usual additive package of the commercially available polymers useful for this invention are adapted to suit the composition of the upper EVA adhesive layer (same non yellowing anti-oxydant system).

To provide protection against humidity, UV radiation and electrical shock, the external PP based layer (11) will have a thickness of typically 0.3 mm

The backsheet with integrated adhesive is preferably a multi-layer colaminated film to limit the risk of pin-hole, particularly in case of high concentration of pigments.

The adhesion of the backsheet to sealants (e.g. sealant of the junction box or aluminium frame) may be improved by treating the surface of the film to be sealed e.g. with a plasma torch (local treatment) or by Corona or by Plasma (preferably atmospheric plasma - N₂ or N₂/H₂ or N₂/NH₃ or N₂/CO₂ or Ar, etc atmosphere). The latter surface treatment is also known as a cementation treatment. Another method to enhance adhesion is to treat the backsheet with Corona treatment and coating a primer like a chlorinated polyolefin primer. Aerosol assisted atmospheric plasma deposition of adhesion promoters likes silanes, e.g. expoxy silanes, is also useful

It is preferred to add at least 5 % TiO₂ in the composition of the layers of the backsheet (10) to obtain color stability and a high solar reflectance. The backsheet and other layers further contain UV light and thermal stabilizers (typically Irgastab FS301) and if required pigments and/or flame retardants and/or acid scavengers and/or anti-blocking material and/or scratch-resistance modifier like Ciba^{®} IRGASURF^{®} SR 100.

To obtain/improve adhesion between the several layers of the PV module, the surfaces coming into contact with each other may be treated beforehand by e.g. Corona, (atmospheric or low pressure) plasma treatment/deposition, plasma polymerization, gamma irradiation, flame treatment, (reactive) sputtering (Al₂O₃, Al,...), wet coating (of e.g. silanes like Aminopropyltriethoxysilane (H₂NC₃H₆-Si(OC₂H₅)₃)), chemical and/or mechanical etching, Chemical Vapor Deposition (e.g. Al₂O₃ on glass), etc, and combinations thereof.

To be able to weld by any suitable technique (hot wedge, etc.), the junction box (601) to the rear face of the backsheet, one produces the Junction Box by injection over molding of a PA 6-6 based composition on a multi-layer ring film (602) consisting of:
- a first (602a) thin layer (typically 50 µm) coming directly into contact with the PA 6-6 based injected Junction Box, being based on acid functionalized PP like a MAH grafted PP composition, e.g. ADMER QF 551E with usual stabilizers.
- a second (602a/b) thicker layer (typically up to 2 mm) coming into contact with the PP backsheet, being preferably based on a FPP material with good welding properties with the PP backsheet.

The temperature of the mold is typically 70°C. The multi-layer ring (obviously matching the geometry of the base of the junction box) is laid on the bottom of the mold. The mold is closed and Polyamide 6-6 (Durethan A30S Lanxess, with useful stabilizers, possibly with glass fiber and fire retardants, etc.) is injected at a melt temperature of 290°C and overmolded on the multi-layer ring. Excellent adhesion with the first layer of the ring film is obtained.

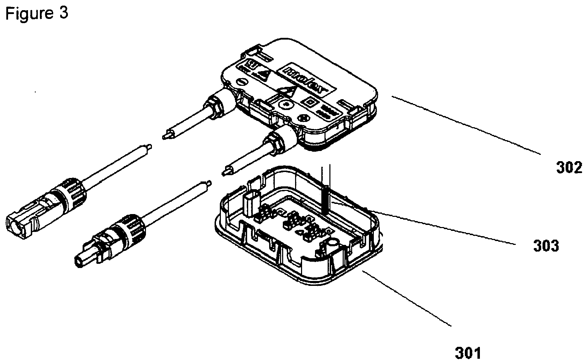

The Junction Box is preferably of the type "with diodes together with the DC cable connections in the "removable" top cover of the housing (see figure 3, 302 - like supplied from Molex)". Only the base (figure 3 - 301) of the junction box is overmolded on the multi-layer ring and this base welded on the preferably FPP rear side of the backsheet.

In case laser welding is used, the base of the junction box will be laser light transparent. The first thin layer of the multi-layer ring film (602a) will also be laser light transparent and the second FPP thicker layer (602b/c) will be a bi-layer film with a first laser light transparent FPP layer (602b) coming into contact with the first transparent thin layer (602a) and a second laser light absorbing (602c) thin FPP layer (e.g. containing carbon black) coming into contact with the (F)PP rear side of the backsheet (10). The second laser (303) light absorbing thin FPP layer 602c) will absorb the laser energy and allows for the required temperature for welding the base of the Junction Box (301, 602) on the backsheet (10).

To achieve a watertight sealing of the backsheet (10) of the module with the Aluminium frame (6001), one provides by extrusion a melted rod of an acid functionalized FPP based compound like on base of a MAH grafted FPP composition. This rod is extruded at 260°C between the preferably preheated aluminium frame (60°C) and the preferably FPP rear face of the backsheet (10).

The invention will be illustrated further by reference to the attached drawings which are not meant to restrict the scope to the specific embodiments shown. Other combinations of the preferred features than those shown are also possible and advantageous. It should be appreciated that for simplicity and clarity of illustration, elements shown in the figures have not necessarily be drawn to scale.

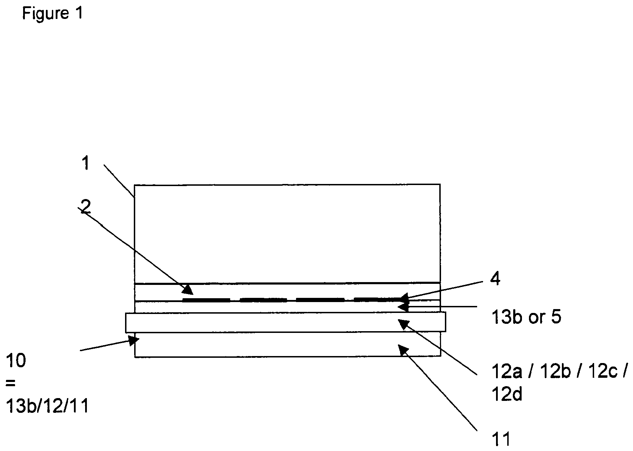

Figure 1 shows a cross section of a PV module with:
i. A top layer (1) (Glas plate or polymeric film provided if required with adequate surface treatment to adhere to layer (2) if used
ii. If required (e.g. for crystalline silicon PV cells) a transparent upper adhesive layer (2) being, e.g. an EVA or a tie-layer/TPO/tie-layer film, etc.
iii. Active layers (4), possibly directly built on glass (1), and provided if required with barrier layers and/or primer layer
iv. A under adhesive layer (5) being a functional (co-)PE tie-layer (13b) with good adhesion to active layers (4) back-electrode or back barrier or back primer coating and to adhesive layer (2),
v. A possibly multi-layer Intermediate layer (12a), having appropriate softness to limit tension on active layer(s) (4) and low residual heat of fusion, adequate viscosity and thickness to encapsulate thick active layer(s) like crystalline silicon PV cells (4).
vi. A Tie-layer (12b)
vii. A Reactive layer (12c)
viii. If desired a Tie-layer (12d)
ix. If desired a Protective layer (11) of Reactive layer (12c) preferably based on a multi-layer (F)PP based layer preferably with an external layer (rear alyer) facing the junction box preferably on base of a FPP reactor blend for weldability to said junction box.

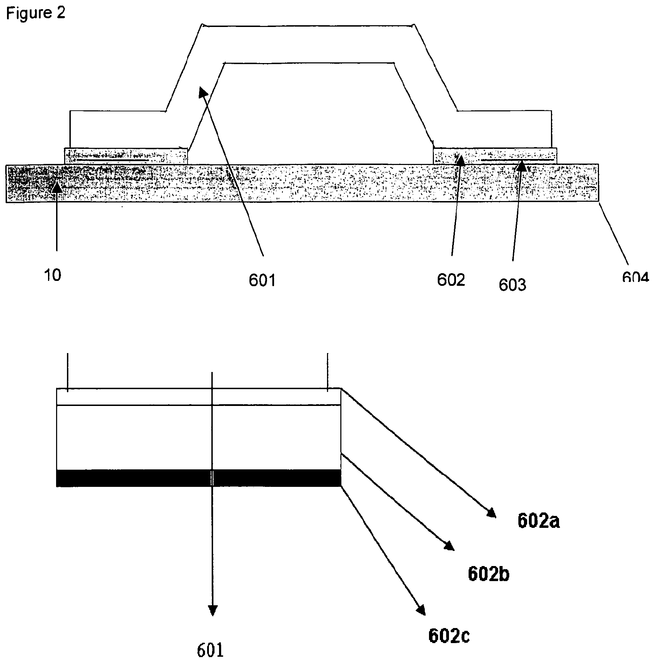

Figure 2 shows a cross section of a junction box (601), welded on the backsheet (10) of this invention, preferably equipped with a FPP layer (11). The junction box may be made of any suitable material including PP or PA 6-6. The junction box may be equipped with a possibly multi-layer ring, i.e. a sealing strips (602), having the size of the base of the Junction Box. Such ring may be on base of FPP material and containing possibly a metal strip (603) to provide eddy current weldability or a resistance to heat and melt the sealing strips. The strip 603 may also be an IR absorbing layer inside the strip 602, to provide IR laser weldability (providing the other layers are IR light transparent). The flaps (604) of the junction box may also be made of FPP based material to allow hot edge or hot air welding of the junction box to FPP layer (11) of the backsheet (10), etc. Another useful technique is Ultra Sonic welding.

If the base of the Junction Box (601) is on base of Polyamide 6-6, the multi-layer ring of sealing strips (602) may consist of a tie-layer (602a) and a thicker FPP layer (602b/c). Thin layer 602c may contain carbon black for allowing laser welding on FPP layer (11) of backsheet (10).

The adhesion between the multi-layer sealing strip ring (602) and the base of the Junction Box (601) is obtained by a compatibilizating layer (602a).

The multi-layer ring film may contain an embedded (603) strip.

Figure 3 shows a Junction Box (301 + 302) of the type "with diodes together with the DC cable connections in the "removable" top cover (302) of the housing (like supplied from Molex). Only the base (301) of the junction box is welded to the backsheet, e.g. on base of a laser beam (303), which follows the inner perimeter of the base (301) of the Junction Box (301 + 302) above the possibly multi-layer sealing ring (not shown). Such ring is possibly previously attached to the base of the junction box during the step of injection of the junction box by the technique of injection overmolding.

Figure 4 shows a DSC analysis (10 K/minute) of:
i. (above) a FPP layer based on Hifax CA 10 A: the melting temperature is around 142°C. The residual heat of fusion above 150°C is less than 5 J/g.
ii. (below) a FPP layer based on Hifax CA 12 A: the melting temperature is around 163°C. The residual heat of fusion above 150°C is around 30 J/g.
To measure the residual heat of fusion by DSC (Differential Scanning Calorimetry) of a polymeric material, one proceeds like for the measurement of the enthalpy of fusion of the polymeric material in question (according to MTM 15902). The polymeric material is heated with a speed of 10K/minute. As can be seen on figure 4 a baseline is drawn which refers to the specific heat (Cp) of the polymeric material. The area (A) between the base line and the curve is used to calculate the Enthalpy of fusion of the polymeric material in test using the following equation: ΔH = K•A, where ΔH is the enthalpy of fusion, K is the calorimetric constant, and A is the area under the curve. The calorimetric constant will vary from instrument to instrument, and is determined by analyzing a well-characterized sample with known enthalpies of transition. The residual heat of fusion, RHf, is obtained by restricting the same area A to the area Ar, on the right of (i.e. above) the lamination temperature: RHf = K•Ar. If the layer on base of polymeric material contains a weight % Wk of inorganic fillers, the residual heat of fusion above lamination temperature of the polymeric part of the layer is obtained by: RHf = K•Ar/(1 - Wf).

It is the first heating measurement which is relevant, i.e. on the material as it will enter the laminator.

As can be understood from figure 4, the melting point of a polymeric material is not sufficient to define its usefulness for this invention. It is indeed possible to have a composition with a sufficient residual heat of fusion at lamination temperature but with a melting point lower than the lamination temperature. Further a material may have an elevated melting point but may be essentially amorphous and have a too low residual heat of fusion.

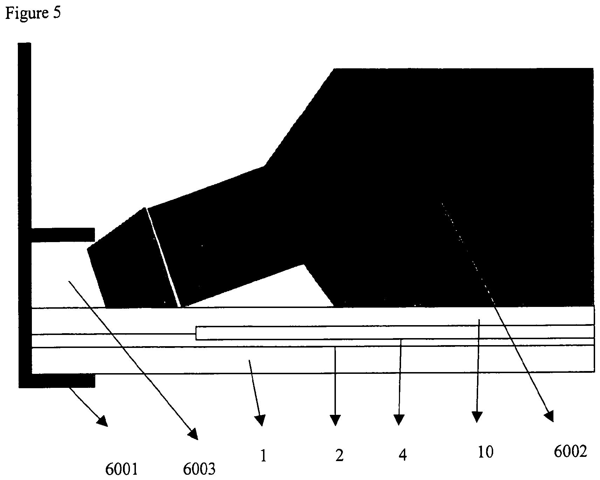

Figure 5 shows a schematic drawing of a Hand Extruder Head (6002) sealing the backsheet (10) of the PV module with the aluminium frame (6001) on base of an extruded rod consisting of a blend on base of a functionalized FPP e.g. with grafted MAH functionalities. The rod is first produced by classical extrusion process and melted by the hand extruder (see Leister Hand Extruder instructions) and pumped in cavity (6003) between the backsheet (10) and aluminium frame (6001) for durable sealing purpose.

### EXAMPLES and BEST MODE of the INVENTION

The invention will be further clarified by the following examples which are not meant to restrict the scope to the specific provided examples. Other combinations of the preferred featues than those shown are also possible and useful.

### Example 1): Backsheet.

By coextrusion/lamination one produces, around 250°C (extrusion temperature), the following multi-layer film:
- Tie-Layer Layer one (13b) = 25 µm thick layer based on LLDPE-MAH grafted like Orevac 18300 from Arkema, with additives e.g. like Tinuvin NOR 371 FF: 0.8 parts, Chimassorb 81: 0.2 parts, Irgastab FS301 : 0.3 parts, possibly with pigments like TiO₂ (without pigments if the layer flows until above the PV cells).
- Intermediate Multi-layer Layer two (12a):
   - 100 µm Sublayer (12a1) in contact with layer (13b) with following composition:
      ∘ Exact 0201 (VLDPE resin from Dexplastomer): 100 parts
      ∘ TiO2 Kronos 2220: 5 parts ;
      ∘ Chimassorb 2020: 0.8 parts ;
      ∘ Tinuvin 770: 0.2 parts ;
      ∘ Chimassorb 81: 0.2 parts,
      ∘ Irgastab FS301 : 0.3 parts.
      Addition of LLDPE is possible to increase temperature resistance. Addition of softeners (EPR, SEBS resin (Kraton G1657, ...) is also possible.
   - 150 µm Intermediate Sublayer (12a2), an interlocked blend based layer with following composition:
      ∘ Hifax CA 10 A (PP/EPR reactor blend from LyondeIIBaseII): 10 parts
      ∘ Hifax CA 60 (PP/EPR reactor blend from LyondeIIBaseII): 30 parts
      ∘ Versify 2400.01 (elastomer PP resin from DOW): 10 parts
      ∘ Exact 0203 (VLDPE resin from Dexplastomer): 50 parts
      ∘ TiO2 Kronos 2220: 5 parts ;
      ∘ Chimassorb 2020: 0.8 parts ;
      ∘ Tinuvin 770: 0.2 parts ;
      ∘ Chimassorb 81: 0.2 parts,
      ∘ Irgastab FS301 : 0.3 parts.
   - 100 µm Reactor blend based FPP layer (12a3) in contact with layer (12b)
      ∘ Hifax CA 10 A (PP/EPR reactor blend from LyondeIIBaseII): 30 parts
      ∘ Hifax CA 60 (PP/EPR reactor blend from LyondeIIBaseII): 70 parts
      ∘ TiO2 Kronos 2220: 5 parts ;
      ∘ Chimassorb 2020: 0.8 parts ;
      ∘ Tinuvin 770: 0.2 parts ;
      ∘ Chimassorb 81: 0.2 parts,
      ∘ Irgastab FS301 : 0.3 parts.
- Tie-Layer layer three (12b) = 25 µm thick layer based on RCP-MAH grafted like Admer QF 551E from Mitsui, with additives e.g. like Tinuvin NOR 371 FF: 0,8 parts, Chimassorb 81: 0.2 parts, Irgastab FS301: 0.3 parts, possibly with pigments like carbon black or TiO₂.
- Reactive Layer layer 4 (12c) = 200 µm thick layer based on PA 6 (PA6 Ultramid B36LN from BASF) with usual stabilizers, additives and pigments, and if required with usual hydrolysis stabilizer
- Tie-Layer layer 5 (12d) = 25 µm thick layer based on RCP-MAH grafted like Admer QF 551E from Mitsui, with additives e.g. like Tinuvin NOR 371 FF: 0.8 parts, Chimassorb 81: 0.2 parts, Irgastab FS301 : 0.3 parts, possibly with pigments like carbon black or TiO₂.
- Protective FPP multi-layer layer 6 (11):
   - (11a) A 50 µm layer in contact with layer 5 (12d), on base of Hifax CA 10 A and Hifax CA 60 (same additives as layer (12a3)).
   - (11b) A 300 µm core layer on base of a homopolymer PP impact modified, with additives like layer (12a3)
   - (11a) A 50 µm rear layer on base of Hifax CA 10 A and Hifax CA 60 (same additives as layer 12a3)

Layers 13b/13a1/13a2/13a3 are first coextruded and then colaminated with coextrude layers 12b/12c/12d and such complex is then colaminated with coextruded layers 11a/11b/11c.

Tinuvin 770 and Chimassorb 81 are common HALS and UV absorbers of crosslinkable EVA adhesive layer (2). Such additives will migrate within and from the backsheet (10) to the EVA layer (2) to compensate losses (by migration, by peroxides degradation/reactions, ...). Irgastab FS301 is an anti-oxydant from Ciba

### Example 2): PV module.

In a classical Meyer vacuum laminator (membrane press), one produces a PV module of the following composition:
a) A 4 mm glass plate (1), possibly with surface treatment like a deposition of a noano-layer of Al₂O₃ by pyrolitic decomposition a salt of Aluminium
b) An EVA adhesive layer (2) or an ionomer layer or a tie-layer/transparent TPO (VLDPE, ...)/tie-layer
c) Interconnected Crystalline Silicon Cells (4) or thin film cells on plastic, etc., possibly with treated surfaces to better adhere to b (2) and d (10))
d) A back-adhesive integrated backsheet (10) "13b /12 a/12b/12c/12/11", from example 1),
according to conditions well known by the man skilled in the art (30minutes cycle - 145°C).

The adhesion between the adhesive integrated backsheet "13b /12 a/12b/12c/12/11" and EVA (2) is measured by peeling according to EN 12316-2. The adhesion is excellent (> 40 N/cm) and no internal delamination is observed thanks to the excellent compatibility between the several layers.

After immersion in water 60°C during 3 months, the adhesion remains excellent. The produced module is free of defect.

As will be apparent the foregoing description does not cover all possible combinations. Other combinations may be derived by the man skilled in the art from the present description and are useful.

### List of reference numbers

- 1: top layer
- 2: upper adhesive layer
- 4: photovoltaic cells, active material
- 5: back adhesive layer
- 10: backsheet
- 11: (F)PP protective layer
- 12d: PP based tie-layer (e.g. based on PP grafted with MAH)
- 12c: Reactive layer
- 12b: PE or PP based tie-layer
- 12a: Intermediate layers
- 13b: PE based tie-layer in direct contact with the PV cells (4)

- 601: junction box
- 602: sealing strip
- 603: metal strip
- 604: flap
- 602a: junction box connecting layer of sealing strip
- 602b: main layer of sealing strip
- 602c: laser light absorbing layer of sealing strip

- 301: junction box base
- 302: junction box cover
- 303: laser beam following the perimeter of the junction box base

- 6001: Aluminium frame
- 6002: Extrusion head of hand extruder
- 6003: Cavity where the sealing material is pumped into

## Claims

1. A multi-layer backsheet (10) for a PV module, wherein the backsheet (10) comprises a heat resistant reactive layer (12c) on base of (co-)polyamide or EVOH and having a residual heat of fusion at lamination temperature attached by coextrusion to a PO based tie-layer (12b) of the backsheet (10) and wherein the PO based tie-layer (12b) facing an active layer (4) is based on a MAH grafted PolyPropylene and an external layer (either 12a or 13b) between the PO based tie-layer (12b) and the active layer (4) of the PV module is based on a TPO resin or blend which has a residual heat of fusion at lamination temperature of less than 30 J/g, preferably less than 5 J/g, most preferably is melted, whereby the residual heat of fusion at lamination temperature is measured by DSC according to MTM 15902.

2. A backsheet (10) according to claim 1, equipped with a protective layer (11) at the reactive layer (12c) opposite to the PO based tie-layer (12b), wherein the protective layer (11) is on base of PolyPropylene resin, preferably being a coextruded multi-layer with a rear layer facing the junction box on base of a Flexible PolyPropylene blend, preferably a UV and heat stabilized and opacified FPP reactor blend.

3. A backsheet (10) according to claim 2, where the reactive layer (12c) and the protective layer (11) are attached together by a layer (12d) on base of a MAH grafted PolyPropylene.

4. A backsheet (10) according to at least one of claims 1 to 3, where the PO based tie-layer (12b) is provided with a layer on base of a PP/PE interlocked blend having preferably a 2% secant E modulus (ASTM D882) lower than 250 MPa, most preferably lower than 100 MPa.

5. A backsheet (10) according to at least one of claims 1 to 4, further provided with a soft (co-)PolyEthylene intermediate layer (12a) on the PO based tie-layer (12b) opposite to the reactive layer (12c), the intermediate layer (12a) having preferably a 2% secant E modulus (ASTM D882) lower than 250 MPa, most preferably lower than 100 MPa.

6. A backsheet (10) according to claim 4 or 5, further provided with a layer (13b) on base of a (co-)PE tie layer resin on the PO based tie-layer (12b) opposite to the reactive layer (12c).

7. A PV module comprising a backsheet (10) according to anyone of claims 1 to 6.

8. A PV module according to claim 7, comprising an upper adhesive layer (2) between a top layer (1) and active layers (4), wherein the upper adhesive layer (2) is based on ionomers or on PE tie-layers or on transparent (co-)Polyethylene with external layers on base of PE tie-layers.

9. A PV module according to at least one of claims 7 or 8, wherein at least one PE tie-layer is based on (co-)PE grafted with Maleic Anhydride, preferably on (co-)PE grafted with less than 1% weight of Maleic Anhydride.

10. A PV module according to at least one of claims 7 to 9, wherein a junction box is welded on the backsheet (10), preferably on a FPP based layer (11).

11. A PV module according to at least one of claims 7 to 9, wherein a junction box is glued on the at least locally plasma surface treated backsheet (10).

12. A PV module according to at least one of claims 7 to 11, wherein the layer (13b) facing the active layers (4) and intermediate layer(s) (12a) provided between the layer (13b) facing the cells and the PO based tie-layer (12b) have adapted thicknesses, viscosity, melting behavior and softness providing controlled lateral flow, limited cell movement, adequate penetration between PV cells with good encapsulation properties and excellent adhesion to crystalline PV cells.

13. A PV module according to at least one of claims 7 to 12, wherein a top layer (1) of the PV module is a glass plate equipped by CVD (pyrolitic decomposition) with a nano-layer of Al2O3, at the upper adhesive layer (2) side.

14. A PV module according to at least one of claims 7 to 13, equipped with an aluminium frame sealed to the backsheet (10) by using an extruded, preferably soft rod with at least an external layer on base of functionalized PP, preferably functionalized FPP, e.g. grafted with maleic anhydride.

15. The use of the backsheet (10) according to anyone of claims 1 to 6 as integrated insulation layer on a metallic or a metal/polymer composite substrate.

## Patentansprüche

1. Mehrschichtige Rückseitenfolie (10) für ein PV-Modul, wobei die Rückseitenfolie (10) eine hitzebeständige reaktive Schicht (12c) auf Basis von (Co-)Polyamid oder EVOH mit einer Restschmelzwärme bei Laminierungstemperatur umfasst, die durch Koextrusion an einer PO-basierten Bindeschicht (12b) der Rückseitenfolie (10) angebracht ist, und wobei die PO-basierte Bindeschicht (12b), die einer aktiven Schicht (4) zugewandt ist, auf einem mit MAH gepfropftem Polypropylen basiert und eine äußere Schicht (entweder 12a oder 13b) zwischen der PO-basierten Bindeschicht (12b) und der aktiven Schicht (4) des PV-Moduls auf einem TPO-Harz oder einer TPO-Mischung basiert, das/die eine Restschmelzwärme bei Laminierungstemperatur von weniger als 30 J/g, vorzugsweise von weniger als 5 J/g aufweist, besonders bevorzugt geschmolzen ist, wobei die Restschmelzwärme bei Laminierungstemperatur mittels DSC gemäß MTM 15902 gemessen wird.

2. Rückseitenfolie (10) gemäß Anspruch 1, die an der reaktiven Schicht (12c) und gegenüber der PO-basierten Bindeschicht (12b) mit einer Schutzschicht (11) ausgestattet ist, wobei die Schutzschicht (11) auf Polypropylenharz basiert, vorzugsweise eine coextrudierte Mehrlagenschicht ist, mit einer dem Anschlusskasten zugewandten, hinteren Schicht, die auf einer flexiblen Polypropylenmischung basiert, vorzugsweise einer UV- und hitzebeständigen und getrübten FPP-Reaktormischung.

3. Rückseitenfolie (10) gemäß Anspruch 2, wobei die reaktive Schicht (12c) und die Schutzschicht (11) durch eine Schicht (12d) auf Basis eines mit MAH gepfropften Polypropylens verbunden sind.

4. Rückseitenfolie (10) gemäß mindestens einem der Ansprüche 1 bis 3, wobei die PO-basierte Bindeschicht (12b) mit einer Schicht auf Basis einer gekuppelten PP/PE-Mischung versehen ist, welche vorzugsweise ein 2 % Sekanten E-Modul (ASTM D882) niedriger als 250 MPa hat, am meisten bevorzugt niedriger als 100 MPa.

5. Rückseitenfolie (10) gemäß mindestens einem der Ansprüche 1 bis 4, die zusätzlich mit einer weichen (Co-)Polyethylen Zwischenschicht (12a) auf der PO-basierten Bindeschicht (12b) gegenüber der reaktiven Schicht (12c) versehen ist, wobei die Zwischenschicht (12a) vorzugsweise ein 2 % Sekanten E-Modul (ASTM D882) niedriger als 250 MPa hat, besonders bevorzugt niedriger als 100 MPa.

6. Rückseitenfolie (10) gemäß Anspruch 4 oder 5, die auf der PO-basierten Bindeschicht (12b) gegenüber der reaktiven Schicht (12c) zusätzlich mit einer Schicht (13b) auf der Basis eines (Co-)PE-Bindeschichtharzes versehen ist.

7. PV-Modul umfassed eine Rückseitenfolie (10) gemäß einem der Ansprüche 1 bis 6.

8. PV-Modul gemäß Anspruch 7, umfassend eine obere Klebschicht (2) zwischen einer Deckschicht (1) und aktiven Schichten (4), wobei die obere Klebschicht (2) auf lonomeren oder auf PE-Bindeschichten oder auf transparentem (Co-)Polyethylen mit äußeren Schichten auf Basis von PE-Bindeschichten basiert.

9. PV-Modul gemäß mindestens einem der Ansprüche 7 oder 8, wobei mindestens eine PE-Bindeschicht auf (Co-)PE gepfropft mit Maleinsäureanhydrid basiert, vorzugsweise auf (Co-)PE gepfropft mit weniger als 1 Gew.-% Maleinsäureanhydrid.

10. PV-Modul gemäß mindestens einem der Ansprüche 7 bis 9, wobei ein Anschlusskasten auf der Rückseitenfolie (10), vorzugsweise auf einer FPP-basierten Schicht (11), aufgeschweißt ist.

11. PV-Modul gemäß mindestens einem der Ansprüche 7 bis 9, wobei ein Anschlusskasten auf die zumindest lokal plasmaoberflächenbehandelte Rückseitenfolie (10) aufgeklebt ist.

12. PV-Modul gemäß mindestens einem der Ansprüche 7 bis 11, wobei die Schicht (13b), die den aktiven Schichten (4) zugewandt ist, und die Zwischenschicht(en) (12a), die zwischen der den Zellen zugewandten Schicht (13b) und der PO-basierten Bindeschicht (12b) vorgesehen sind, angepasste Dicken, Viskosität, Schmelzverhalten und Weichheit aufweisen, um kontrollierte Querströmung, begrenzte Zellenbewegung, angepasste Penetration zwischen PV-Zellen mit guten Verkapselungseigenschaften und ausgezeichnete Haftung an kristallinen PV-Zellen bereitzustellen.

13. PV-Modul gemäß mindestens einem der Ansprüche 7 bis 12, wobei eine Deckschicht (1) des PV-Moduls eine Glasplatte ist, die auf der Seite der oberen Klebschicht (2) mittels CVD (pyrolitische Zersetzung) mit einer Nanoschicht aus Al2O3 ausgestattet ist.

14. PV-Modul gemäß mindestens einem der Ansprüche 7 bis 13, ausgestattet mit einem mit der Rückseitenfolie (10) unter Verwendung eines extrudierten, vorzugsweise weichen Stabes mit mindestens einer äußeren Schicht auf Basis von funktionalisiertem PP, vorzugsweise funktionalisiertem FPP, z.B gepfropft mit Maleinsäureanhydrid, versiegelten Aluminiumrahmen.

15. Verwendung der Rückseitenfolie (10) gemäß einem der Ansprüche 1 bis 6 als integrierte Isolationsschicht auf einer metallischen oder einer Metall/Polymer-Verbund-Basisplatte.

## Revendications

1. Feuille de support multicouche (10) pour un module PV, la feuille de support (10) comprenant une couche réactive thermorésistante (12c) à base de (co-)polyamide ou EVOH et ayant une chaleur de fusion résiduelle à la température de stratification attachée par coextrusion sur une couche de liaison à base de PO (12b) de la feuille de support (10) et dans laquelle la couche de liaison à base de PO (12b) faisant face à une couche active (4) est à base d'un PolyPropylène greffé par MAH et une couche externe (soit 12a, soit 13b) entre la couche de liaison à base de PO (12b) et la couche active (4) du module PV est à base d'une résine ou d'un mélange homogène de TPO qui a une chaleur de fusion résiduelle à la température de stratification inférieure à 30 J/g, de préférence inférieure à 5 J/g, de manière préférée entre toutes qui est fondu, la chaleur de fusion résiduelle à la température de stratification étant mesurée par DSC selon la MTM 15902.

2. Feuille de support (10) selon la revendication 1, équipée d'une couche protectrice (11) au niveau de la couche réactive (12c) opposée à la couche de liaison à base de PO (12b), dans laquelle la couche protectrice (11) est à base de résine de PolyPropylène, qui est de préférence une multicouche coextrudée avec une couche arrière faisant face à la boîte de jonction à base d'un mélange homogène de PolyPropylène Flexible (FPP), de préférence d'un mélange homogène en réacteur de FPP stabilisé aux UV et à la chaleur et opacifié.

3. Feuille de support (10) selon la revendication 2, où la couche réactive (12c) et la couche protectrice (11) sont attachées ensemble par une couche (12d) à base d'un PolyPropylène greffé par MAH.

4. Feuille de support (10) selon au moins l'une des revendications 1 à 3, où la couche de liaison à base de PO (12b) est pourvue en outre d'une couche à base d'un mélange homogène enchevêtré de PP/PE ayant de préférence un module E sécant à 2 % (ASTM D882) inférieur à 250 MPa, de manière préférée entre toutes inférieur à 100 MPa.

5. Feuille de support (10) selon au moins l'une des revendications 1 à 4, pourvue en outre d'une couche intermédiaire de (co)PolyÉthylène souple (12a) sur la couche de liaison à base de PO (12b) opposée à la couche réactive (12c), la couche intermédiaire (12a) ayant de préférence un module E sécant à 2 % (ASTM D882) inférieur à 250 MPa, de manière préférée entre toutes inférieur à 100 MPa.

6. Feuille de support (10) selon la revendication 4 ou la revendication 5, pourvue en outre d'une couche (13b) à base d'une résine de couche de liaison de (co)PE sur la couche de liaison à base de PO (12b) opposée à la couche réactive (12c).

7. Module PV comprenant une feuille de support (10) selon l'une quelconque des revendications 1 à 6.

8. Module PV selon la revendication 7, comprenant une couche adhésive supérieure (2) entre une couche de dessus (1) et des couches actives (4), dans lequel la couche adhésive supérieure (2) est à base d'ionomères ou de couches de liaison de PE ou de (co)Polyéthylène transparent avec des couches externes à base de couches de liaison de PE.

9. Module PV selon au moins l'une des revendications 7 ou 8, dans lequel au moins une couche de liaison de PE est à base de (co)PE greffé par de l'Anhydride Maléique, de préférence de (co)PE greffé avec moins de 1 % en poids d'Anhydride Maléique.

10. Module PV selon au moins l'une des revendications 7 à 9, dans lequel une boîte de jonction est soudée sur la feuille de support (10), de préférence sur une couche à base de FPP (11).

11. Module PV selon au moins l'une des revendications 7 à 9, dans lequel une boîte de jonction est collée sur la feuille de support (10) traitée en surface au moins localement au plasma.

12. Module PV selon au moins l'une des revendications 7 à 11, dans lequel la couche (13b) faisant face aux couches actives (4) et la ou les couches intermédiaires (12a) prévues entre la couche (13b) faisant face aux cellules et la couche de liaison à base de PO (12b) ont des épaisseurs, une viscosité, un comportement thermofusible et une souplesse adaptés fournissant un écoulement latéral régulé, un déplacement cellulaire limité, une pénétration adéquate entre des cellules PV avec de bonnes propriétés d'encapsulation et une excellente adhérence à des cellules PV cristallines.

13. Module PV selon au moins l'une des revendications 7 à 12, dans lequel une couche de dessus (1) du module PV est une plaque en verre équipée par CVD (décomposition pyrolytique) d'une nanocouche d'Al₂O₃, au niveau du côté de la couche adhésive supérieure (2).

14. Module PV selon au moins l'une des revendications 7 à 13, équipé d'un cadre en aluminium scellé sur la feuille de support (10) à l'aide d'une tige extrudée, de préférence souple, avec au moins une couche externe à base de PP fonctionnalisé, de préférence de FPP fonctionnalisé, par exemple greffé par de l'anhydride maléique.

15. Utilisation de la feuille de support (10) selon l'une quelconque des revendications 1 à 6 en tant que couche isolante intégrée sur un substrat composite métallique ou de métal/polymère.
